# DEMANDE DE BREVET EUROPEEN

(11) **EP 3 764 756 A1**
(43) Date de publication de la demande: **13.01.2021**
(21) Numéro de dépôt: 20184819.9
(22) Date de dépôt: 08.07.2020
(51) Int. Cl.: H05K 1/18, H01L 23/552, H05K 3/46

(54) **COMPOSANT ELECTRONIQUE RESISTANT A L'HUMIDITE ET PROCEDE DE REALISATION D'UN TEL COMPOSANT**

(30) Priorité: 11.07.2019 FR 1907784
(71) Demandeur: THALES, 92400 Courbevoie (FR)
(72) Inventeur: KERTESZ, Philippe, 78851 ELANCOURT Cedex (FR)
(74) Mandataire: Marks & Clerk France

(57) **Abrégé**

L'invention concerne un composant électronique (10) comprenant un premier ensemble (11) comprenant une couche d'interconnexion (12) et un circuit électronique (13) ayant une face avant (14) et une face arrière (15), connecté à la couche d'interconnexion (12) par la face avant (14), caractérisé en ce que le premier ensemble (11) comprend :
a. une plaque métallique (16) ayant une face avant (17) et une face arrière (18), assemblée sur la face arrière (15) du circuit électronique (13) ;
b. un agent de couplage (19) entre la face avant (17) de la plaque métallique (16) et la face arrière (15) du circuit électronique (13) configuré pour connecter thermiquement et électriquement la plaque métallique (16) au circuit électronique (13) ;
et en ce que le composant électronique (10) comprend :
c. une ou plusieurs couches en matériaux organiques (20, 21, 22, 23, 24, 25) empilées autour du premier ensemble (11) et de la plaque métallique (16) selon une technique de type circuit imprimé et encapsulant le circuit électronique (13);
d. une surface métallique (26) thermiquement conductrice disposée en contact au moins partiellement avec la face arrière (18) de la plaque métallique (16).

## Description

La présente invention concerne un composant électronique, notamment hyperfréquences, résistant à l'humidité. Elle concerne également un procédé de réalisation d'un composant électronique, notamment hyperfréquences.

L'invention se situe notamment dans le domaine du packaging microélectronique hyperfréquences, en particulier pour réaliser des boîtiers hyperfréquences comportant un blindage intégré et résistant à l'humidité. Ces boîtiers sont par exemple utilisés dans des équipements hyperfréquences complexes tels que des radars aéroportés. Plus généralement, le domaine d'application est celui des équipements hyperfréquences bande étroite ou large bande, les boîtiers étant utilisables dans toutes les applications haute fréquence, même celles avec des spécifications élevées d'intégrité du signal.

Les technologies de packaging hyperfréquences résistant à l'humidité proposées actuellement, reposent sur l'emploi de matériaux inorganiques ou sur l'encapsulation des composants par des résines organiques injectées. Les solutions inorganiques font notamment appel à des boîtiers hermétiques métalliques à perles de verre pour les entrées/sorties ou céramiques.

Les solutions utilisant des matériaux inorganiques présentent plusieurs inconvénients. On obtient notamment :
- Des boîtiers chers et lourds, du fait des matériaux utilisés, métal ou céramique ;
- Des solutions encombrantes, utilisant notamment des boîtiers à cavités internes, très souvent avec des interconnexions périphériques ;
- Des solutions dont la fiabilité de report, dans l'équipement concerné, est généralement problématique, du fait de différences de coefficient de dilatation avec les circuits imprimés sur lesquels elles sont assemblées.

Dans le cas des packagings organiques injectés, on aboutit à des objets qui sont généralement intrinsèquement non blindés électriquement et qui ne peuvent donc pas être utilisés tels quels dans des équipements complexes où la diaphonie est un paramètre critique. Le boîtier usuellement rencontré est le boîtier dit QFN (« Quad Flat No-Lead ») qui a des entrées et sorties généralement périphériques.

Il y a un besoin pour des boîtiers compacts répondant aux contraintes suivantes :
- Protéger les fonctions encapsulées de l'humidité, notamment pour prendre en compte toutes les technologies MMIC (Microwave Monolithique Integrated Circuit) ;
- Obtenir une bonne fiabilité des reports ;
- Maintenir la possibilité de changer les boîtiers sur la carte ;
- Etre aptes à dissiper les calories ;
- Avoir une capacité à pouvoir faire du 3D, c'est-à-dire suivant les architectures, même avec des boîtiers ultra compacts, empiler des fonctions hyperfréquences suivant la densité d'intégration des puces utilisées.

Les applications hyperfréquences requièrent l'usage de semi-conducteurs III-V à haute mobilité de charges. Ces composants fonctionnent en mode analogique et sont donc très sensibles à la qualité des interconnexions qu'elles utilisent ainsi qu'aux interférences qu'elles peuvent rencontrer. De plus, ceux-ci fonctionnant à des tensions et des courants significatifs, les constituants électroniques (transistors, capacités, résistances ...) peuvent subir des phénomènes de corrosion lorsque ceux-ci sont en fonctionnement, par exemple des corrosions électrochimiques par différence de potentiel de Nernst.

Pour éviter tout problème de fiabilité les industriels ont d'abord développé des boîtiers hermétiques utilisant des matériaux inorganiques (métaux ou céramiques comme indiqué précédemment) qui sont lourds et encombrants. Afin de réduire la masse, le volume et le prix de fabrication des packagings hyperfréquences, des boîtiers plastiques ont commencé à être développés avec une perte de performances électromagnétiques importante mais acceptable pour les applications en bande étroite comme la téléphonie mobile.

Le domaine du packaging électronique a fait l'objet de nombreux développements. Le boîtier de type BGA (Ball Grid Array) à interconnexion surfaciques a été développé en réponse à la technologie QFP (Quad Flat Pack) à interconnexion périphériques afin d'accroître la densité d'interconnexion. Ce type de boîtiers BGA a connu un grand essor pour les applications numériques à base de semi-conducteurs en silicium.

Dans le domaine des packagings organiques hyperfréquences, de nombreuses solutions ont également été développées. Parmi ces solutions, on peut citer la technologie CSP (Chip Scale Package) pour des applications à bande étroite avec une fréquence opérationnelle inférieure à 2,17 GHz. Des boîtiers plastiques susceptibles de gérer des dissipations thermiques de l'ordre de 60 W à 100 W ont aussi été mis au point pour des applications allant jusqu'à 2,17 GHz. Il existe des boîtiers plastiques pour des applications hautes fréquences, jusqu'à 35 GHz, en bande étroite de type QFN. Des boîtiers plastiques de type QFN ou TSOP (Thin Small Outline Package) fonctionnent jusqu'à 12 GHz. Un boîtier à cavité utilisant un matériau thermoplastique dit LCP (Liquid Crystal Polymer) a été développé à la fin des années 2000 pour des applications à hautes fréquences. Durant la même période le concept de packaging pour applications hyperfréquences, en technologie LTCC (Low Temperature Cofired Ceramic) et en matériaux organiques LCP, a vu le jour. Le boîtier de type QFP (Quad Flat Pack), à cavité, a permis l'encapsulation avec des performances satisfaisantes, d'une fonction large bande.

Par ailleurs, des demandes de brevet FR 2849346 et FR 2877537 décrivent une technologie de packaging organique BGA à cavité.

Comme cela a été indiqué précédemment, les seules technologies de packaging hyperfréquences résistantes à l'humidité compatibles de tous les MMIC reposent sur l'emploi de matériaux inorganiques (boîtiers métalliques à perles de verre pour les entrées et sorties ou boîtiers céramiques), ou sur l'encapsulation des composants par des résines organiques injectées. Les solutions à base de matériaux inorganiques conduisent à l'utilisation de boîtiers chers et lourds, et sont encombrantes, en particulier en raison des cavités internes et des interconnexions périphériques. Les solutions à base de matériaux organiques ont l'inconvénient majeur de ne pas être blindés électriquement, et ne sont donc pas utilisables dans des équipements complexes où la diaphonie est un paramètre critique sans cloisonnement complémentaire.

Le document EP 3089211 décrit un composant électronique comprenant un circuit électronique et un empilage de couches en matériaux organiques formant une cavité sur un support, le circuit électronique étant logé dans la cavité remplie par un matériau de faible perméabilité à la vapeur d'eau. Ce composant répond aux contraintes mentionnées plus haut. Toutefois, ce composant nécessite une construction avec double référence mécanique liée au collage de la face arrière du circuit encapsulé. Cette construction est nécessaire pour le report de masse électrique utilisé par le composant pour fonctionner et pour la mise en contact avec un drain thermique pour évacuer efficacement la chaleur produite par le circuit pendant son fonctionnement. Cette construction représente une difficulté mécanique qui est résolue par une étape de déformation de la couche d'interconnexion permettant de résoudre le problème de double référence mécanique pendant le pressage. L'étape de déformation est délicate à mettre en œuvre puisqu'elle peut générer des dégradations des connexions du circuit encapsulé.

L'invention vise à pallier tout ou partie des problèmes cités plus haut en proposant à la fois un composant électronique hautement résistant à l'humidité apte à encapsuler des semi-conducteurs AsGa (arséniure de gallium) et GaN (nitrure de gallium) de manière très performante, avec un blindage intégré, ainsi qu'un procédé de réalisation d'un tel composant facile à mettre en œuvre, et sans risque de dégradation des connexions des circuits électroniques encapsulés dans le composant.

A cet effet, l'invention a pour objet un composant électronique comprenant un premier ensemble comprenant une couche d'interconnexion et un circuit électronique ayant une face avant et une face arrière, connecté à la couche d'interconnexion par la face avant, le premier ensemble comprenant :
a. une plaque métallique ayant une face avant et une face arrière, assemblée sur la face arrière du circuit électronique ;
b. un agent de couplage entre la face avant de la plaque métallique et la face arrière du circuit électronique configuré pour connecter thermiquement et électriquement la plaque métallique au circuit électronique ;
et le composant électronique comprenant :
c. une ou plusieurs couches en matériaux organiques empilées autour du premier ensemble selon une technique de type circuit imprimé et encapsulant le circuit électronique;
d. une surface métallique thermiquement conductrice disposée en contact au moins partiellement avec la face arrière de la plaque métallique.

Avantageusement, le composant électronique comprend un réseau d'éléments métalliques disposé à distance du circuit électronique, de sorte à former une cage de Faraday incluant le circuit électronique.

Avantageusement, le réseau d'éléments métalliques est disposé sur le pourtour du composant électronique.

Avantageusement, le réseau d'éléments métalliques est disposé à la périphérie du composant électronique.

Avantageusement, au moins une parmi la ou les couches en matériaux organiques est une couche en matériau thermoplastique.

L'invention concerne aussi un procédé de réalisation d'un composant électronique comprenant un premier ensemble comprenant une couche d'interconnexion et un circuit électronique ayant une face avant et une face arrière, connecté à la couche d'interconnexion par la face avant, le procédé comprenant les étapes suivantes:
a. assemblage d'une plaque métallique ayant une face avant et une face arrière, sur la face arrière du circuit électronique;
b. couplage thermique et électrique de la plaque métallique au circuit électronique par un agent de couplage entre la face avant de la plaque métallique et la face arrière du circuit électronique;
c. empilage d'une ou plusieurs couches en matériaux organiques autour du premier ensemble et de la plaque métallique selon une technique de type circuit imprimé et encapsulant le circuit électronique formant un assemblage ;
d. stratification de l'assemblage ;
e. réalisation d'une surface métallique thermiquement conductrice disposée en contact au moins partiellement avec la face arrière de la plaque métallique.

Avantageusement, le procédé de réalisation selon l'invention comprend une étape de réalisation de blindage du circuit électronique par un réseau d'éléments métalliques disposé à distance du circuit électronique, de sorte à former une cage de Faraday incluant le circuit électronique.

Avantageusement, l'étape de réalisation de blindage du circuit électronique comprend une étape de disposition du réseau d'éléments métalliques sur le pourtour du composant électronique.

Avantageusement, l'étape de réalisation de blindage du circuit électronique comprend une étape de disposition du réseau d'éléments métalliques à la périphérie du composant électronique.

Avantageusement, l'étape de réalisation de la surface métallique thermiquement conductrice disposée en contact au moins partiellement avec la face arrière de la plaque métallique comprend une étape d'usinage du composant électronique vers la face arrière de la plaque métallique et une étape de métallisation.

L'invention sera mieux comprise et d'autres avantages apparaîtront à la lecture de la description détaillée d'un mode de réalisation donné à titre d'exemple, description illustrée par le dessin joint dans lequel :
[Fig.1 ] La figure 1 représente schématiquement une vue en coupe d'un composant électronique connu de l'art antérieur ;
[Fig.2] La figure 2 représente schématiquement une vue en coupe d'un composant électronique selon l'invention ;
[Fig.3] La figure 3 représente schématiquement une vue en coupe d'un mode de réalisation d'un composant électronique selon l'invention ;
[Fig.4] La figure 4 représente schématiquement une vue en coupe d'un autre mode de réalisation d'un composant électronique selon l'invention ;
[Fig.5] La figure 5 représente schématiquement les étapes d'un procédé selon l'invention ;
[Fig.6] La figure 6 représente schématiquement les étapes d'assemblage et de couplage du procédé selon l'invention ;
[Fig.7] La figure 7 représente schématiquement l'étape d'empilage du procédé selon l'invention ;
[Fig.8] La figure 8 représente schématiquement l'étape de stratification du procédé selon l'invention ;
[Fig.9] La figure 9 représente schématiquement les étapes de réalisation d'une surface métallique thermiquement conductrice et de réalisation de blindage du circuit électronique du procédé selon l'invention ;
[Fig.10] La figure 10 illustre une vue de dessus du composant électronique selon un exemple de réalisation de l'invention.

Sur ces figures, dans un souci de clarté, les échelles ne sont pas respectées. Par ailleurs, les mêmes éléments porteront les mêmes repères dans les différentes figures.

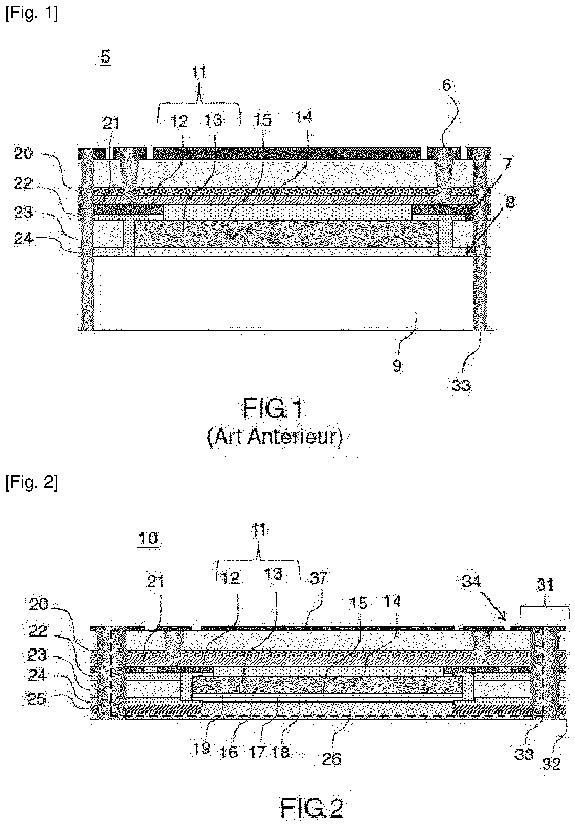

La figure 1 représente schématiquement une vue en coupe d'un composant électronique 5 connu de l'art antérieur. Le composant électronique 5 comprend un support 9 sur lequel est fixé un premier ensemble 11 comprenant une couche d'interconnexion 12 et un circuit électronique 13 ayant une face avant 14 et une face arrière 15, connectée à la couche d'interconnexion 12 par la face avant 14. Il comprend de plus, une ou plusieurs couches en matériaux organiques 20, 21, 22 et 23 empilées sur le support 9. Le circuit électronique 13 est enfermé dans l'ensemble de ces couches après fabrication, interconnecté vers l'extérieur par les structures 6. De même, les structures 33 disposées de manière adaptée tout autour du circuit électronique 13 constituent une cage de Faraday pour le protéger de toute interférence extérieure.

Ce composant électronique 5 de l'art antérieur présente un inconvénient de double référence mécanique (7, 8) liée au collage de la face arrière du circuit. Cette construction est nécessaire car le circuit électronique a besoin pour fonctionner d'être reporté à la masse par sa face arrière 15, et pour la mise en contact avec un drain thermique (symbolisé par la référence 9, qui peut aussi jouer le rôle de support) pour évacuer efficacement la chaleur produite par le circuit électronique pendant son fonctionnement. Lors du procédé de réalisation d'un tel composant, le drain 9 et les couches 21, 22 sont empilées de sorte à former une cavité pour le circuit 13, puis le premier ensemble 11 est positionné. Selon la hauteur des couches 21, 22, 23 autour de la cavité et selon la hauteur du circuit 13 et de ses points de connexion, on ne peut pas garantir que la face arrière 15 appuie sur la colle. En effet, il existe des tolérances mécaniques pour chaque élément. Selon ces tolérances, le circuit 13 peut ne pas être en contact avec la colle en fond de cavité. Afin d'assurer le collage du circuit 13 en fond de cavité, une étape de déformation de la couche d'interconnexion 12 est nécessaire, par pressage sur le premier ensemble 11 vers le drain 9. Lors de cette étape de déformation, les connexions du circuit électronique 13 peuvent être dégradées. Le circuit électronique 13 lui-même peut être endommagé. De plus, en appliquant une pression sur l'empilage, de la colle peut fuir sur les côtés du circuit électronique 13 et conduire à un court-circuit. L'épaisseur entre la face arrière 15 du circuit 13 et la colle avant empilage n'est pas complètement maîtrisée. Les tolérances mécaniques rendent un tel procédé de réalisation délicat et difficile à maîtriser.

La figure 2 représente schématiquement une vue en coupe d'un composant électronique 10 selon l'invention. Le composant électronique 10 comprend un premier ensemble 11 comprenant une couche d'interconnexion 12 et un circuit électronique 13 ayant une face avant 14 et une face arrière 15, connecté à la couche d'interconnexion 12 par la face avant 14. Selon l'invention, le premier ensemble 11 comprend une plaque métallique 16 ayant une face avant 17 et une face arrière 18, assemblée sur la face arrière 15 du circuit électronique 13, par un agent de couplage 19 entre la face avant 17 de la plaque métallique 16 et la face arrière 15 du circuit électronique 13 configuré pour connecter thermiquement et électriquement la plaque métallique 16 au circuit électronique 13. Le composant électronique 10 comprend une ou plusieurs couches en matériaux organiques 20, 21, 22, 23, 24, 25 empilées autour du premier ensemble 11 selon une technique de type circuit imprimé et encapsulant le circuit électronique 13. La couche 25 est une couche de fermeture inférieure qui comporte un feuillard de cuivre qui a été collé dessus préalablement par le fournisseur de matière ou le fabricant du boîtier. Enfin, le composant électronique 10 comprend une surface métallique 26 thermiquement conductrice disposée en contact au moins partiellement avec la face arrière 18 de la plaque métallique 16. Des trous métallisés 33 traversent la périphérie du composant pour relier électriquement le plan conducteur 26 formant le drain avec le plan conducteur supérieur 37 apte à supporter des billes de connexion externe.

La plaque métallique 16 protège la face arrière 15 du circuit électronique 13 pendant le procédé de réalisation du composant 10, elle participe au report de masse, et elle participe aussi à la dissipation thermique de la chaleur produite par le circuit électronique 13 lors de son fonctionnement. Sur la figure 2, la plaque métallique 16 est de surface sensiblement égale à celle de la face arrière du circuit électronique 13. Toutefois, elle pourrait être de surface inférieure ou égale à celle de la face arrière du circuit 13 pour faciliter sa mise en place, ou bien de surface supérieure pour permettre de faire des interconnexions dans la zone où il n'y a pas le circuit électronique 13. Cette dernière variante permet aussi d'augmenter la surface de contact avec la surface métallique 26, et donc de favoriser la dissipation thermique.

Le circuit électronique 13 peut être un circuit hyperfréquences de type MMIC (pour son acronyme anglo-saxon Monolithic Microwave Integrated Circuit). Une des couches, par exemple la couche 20, 21, 22, 23, 24, 25 peut être en matériau thermoplastique LCP, c'est-à-dire en polymère à cristaux liquides (LCP est l'acronyme anglo-saxon Liquid Crystal Polymer). Ce matériau présente une très faible perméabilité à la vapeur d'eau. L'utilisation d'un matériau thermoplastique du type LCP intrinsèquement très peu hydrophile permet, lors de sa déformation pendant le procédé de réalisation, le remplissage des cavités pouvant préexister entre les différentes couches et ainsi d'obtenir des empilages homogènes et résistants à la pénétration d'eau. De plus, à sa température de fusion, le LCP devient quasi-liquide et n'exerce plus de contrainte mécanique. Cette propriété permet de conserver l'intégrité de structures hyperfréquences fragiles telles que les ponts à air que l'on trouve sur beaucoup de circuits de type MMIC. En outre, l'utilisation de matériaux thermoplastiques dans la réalisation d'un tel composant permet de combler tous les défauts, c'est-à-dire cavités, interstices, différence de planéité, de l'empilage lors de sa fabrication. Associée à des matériaux thermodurcissables rigides, l'utilisation de matériaux thermoplastiques garantit le maintien de dimensions mécaniques indispensables au fonctionnement du composant électronique. De plus, l'emploi de matériaux spécifiquement développés pour des usages haute fréquence permet la conception de boîtiers hyperfréquences large bande. En d'autres termes, le composant semiconducteur électronique 10 selon l'invention est « enfermé » dans un empilage de couches de différentes matières plastiques : certaines de ces couches sont faites avec des matériaux « stables » dimensionnellement dans la gamme de température utilisée pendant le procédé de fabrication, et certaines de ces couches « fondent » pendant la montée de température du procédé de fabrication : durant cette phase où elles sont « fondues », ces couches remplissent tous les interstices qui subsistaient avec le composant et l'empilage. Lorsque la température redevient normale, les couches redeviennent rigides : on obtient alors un empilage très proches de celui de départ, mais dont les trous, manques, interstices présents sont remplis.

L'agent de couplage 19 peut être une colle assurant un couplage thermique et électrique du circuit 13 à la plaque métallique 16. Il peut aussi s'agir d'une brasure d'alliage métallique.

Le composant électronique 10 comprend avantageusement un réseau 31 d'éléments métalliques 32, 33 disposé à distance du circuit électronique 13, de sorte à former une cage de Faraday 34 incluant le circuit électronique 13. La cage de Faraday 34 est ainsi constituée entre les éléments 32, 33 et les plans de masse inférieur 26 et supérieur 37. Sur la figure 2, la cage de Faraday est symboliquement représentée (en partie) en pointillés.

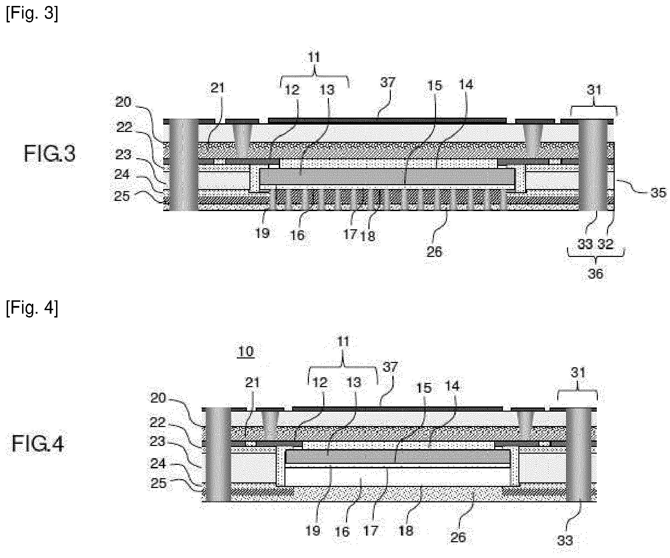

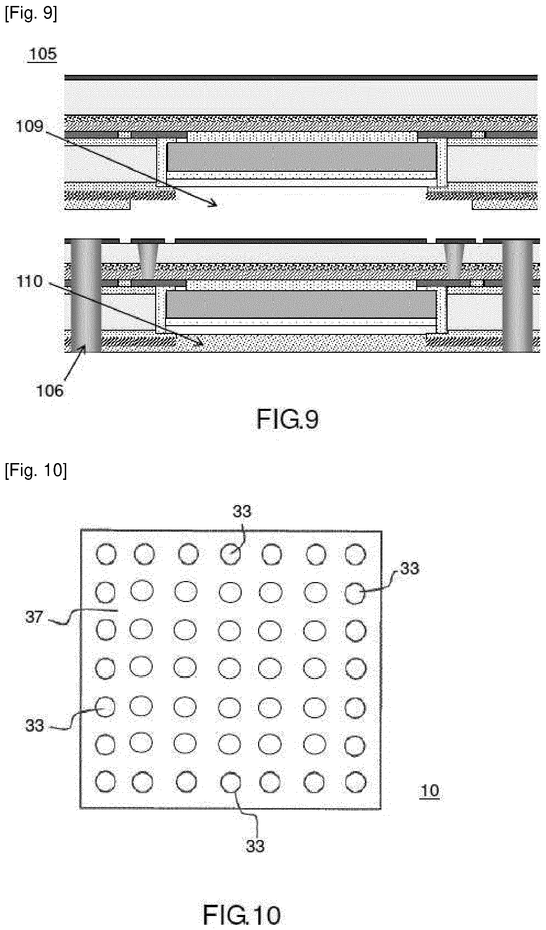

La figure 3 représente schématiquement une vue en coupe d'un mode de réalisation d'un composant électronique 10 selon l'invention. Dans ce mode de réalisation, le réseau 31 d'éléments métalliques 32 est disposé sur le pourtour 35 du composant électronique 10, c'est-à-dire sur la périphérie latérale extérieure du composant électronique 10, par exemple par dépôt d'une couche métallisée sur la surface extérieure du composant, constituant ainsi un vrai mur de blindage. La périphérie latérale extérieure correspond à la surface du composant s'étendant selon un plan sensiblement perpendiculaire au plan d'assemblage du composant, par exemple et pour illustration perpendiculairement à la couche d'interconnexion 12. On peut noter que le réseau 31 d'éléments métalliques 33 peut aussi être disposé à la périphérie 36 du composant électronique, par exemple au moyen de trous métallisés traversants 33. Un composant selon l'invention peut comprendre l'une ou l'autre des variantes d'éléments métalliques, ou bien les deux variantes. Dans le cas de trous métallisés traversants 33, il peut y en avoir deux rangées ou plus, disposées en quinconce. Des trous métallisés 33 traversent la périphérie du composant pour relier électriquement le plan conducteur 26 formant le drain avec le plan conducteur supérieur 37 apte à supporter des billes de connexion externe. Ces trous sont disposés sur toute la périphérie 36 du composant, par exemple de façon régulière, pour former une cage de Faraday délimitée par le plan conducteur supérieur 37 et le plan conducteur 26 et par le réseau de trous métallisés 33. La figure 10 illustre, par une vue de dessus du composant 10, un exemple de disposition de ces trous 33 à la surface. On obtient ainsi un packaging intrinsèquement blindé par la réalisation d'une cage de Faraday interne couplé à un mode d'interconnexion en mode quasi coaxial.

La surface métallique 26 thermiquement conductrice disposée en contact de la couche 25, peut être connectée au moins partiellement avec la face arrière 18 de la plaque métallique 16 et peut former un contact électrique surfacique sur toute la surface de la plaque métallique 16 (comme représenté sur la figure 2), sur une partie de la surface de la plaque métallique 16 et/ou peut avoir une surface supérieure à celle de la plaque métallique 16. La surface métallique 26 peut aussi être constituée par un ensemble de trous métallisés remplis, formant une pluralité des contacts surfaciques. Cette surface métallique peut être constituée de cuivre, comme expliqué ci-dessous dans l'illustration du procédé de réalisation d'un tel composant.

La figure 4 représente schématiquement une vue en coupe d'un autre mode de réalisation d'un composant électronique 10 selon l'invention. Dans ce mode de réalisation, la plaque métallique 16 a une épaisseur plus importante que celle des composants des modes de réalisation présentés aux figures 2 et 3. Cela conduit à un drain thermique final plus épais, ce qui est particulièrement intéressant si une plus grande dissipation de chaleur est nécessitée.

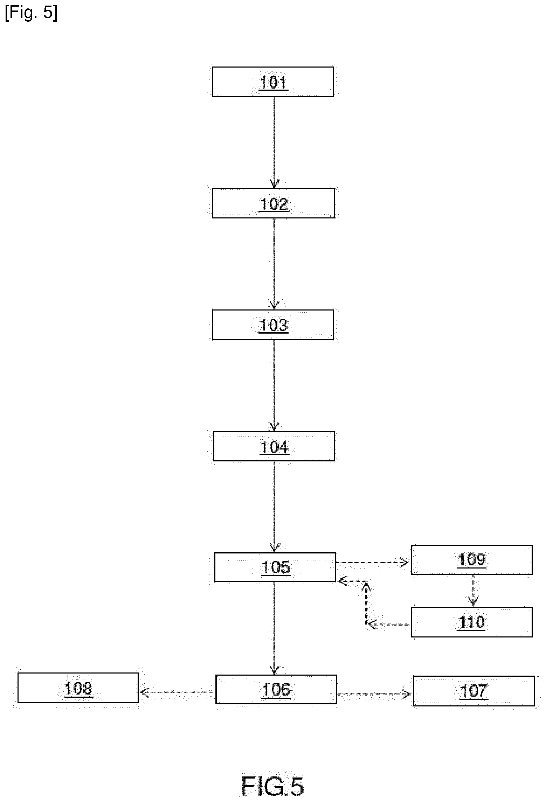

La figure 5 représente schématiquement les étapes d'un procédé selon l'invention. Le procédé de réalisation d'un composant électronique 10 comprenant un premier ensemble 11 comprenant une couche d'interconnexion 12 et un circuit électronique 13 ayant une face avant 14 et une face arrière 15, connecté à la couche d'interconnexion 12 par la face avant 14, comprend une étape 101 d'assemblage d'une plaque métallique 16 ayant une face avant 17 et une face arrière 18, sur la face arrière 15 du circuit électronique 13. Après câblage du circuit électronique 13 sur la couche d'interconnexion 12, une plaque métallique 16 est connectée en face arrière du circuit électronique 13. Cette plaque métallique 16 assure deux fonctions : tout d'abord elle protège la face arrière du circuit électronique 13 lors du procédé (notamment lors de l'usinage du composant en fin de mise en œuvre du procédé comme expliqué plus tard), et elle permet une adaptation thermomécanique de l'interface créée avec les matériaux organiques destinés à y être collés dessus. Par exemple, la plaque métallique 16 peut être en cuivre, ou en cuivre doré, en diamant, etc.

Le procédé selon l'invention comprend une étape 102 de couplage thermique et électrique de la plaque métallique 16 au circuit électronique 13 par un agent de couplage 19 entre la face avant 17 de la plaque métallique 16 et la face arrière 15 du circuit électronique 13. Le couplage thermique et électrique peut être par exemple réalisé au moyen d'une colle ou une brasure. Il comprend ensuite une étape 103 d'empilage d'une ou plusieurs couches en matériaux organiques 20, 21, 22, 23, 24, 25 autour du premier ensemble 11 selon une technique de type circuit imprimé et encapsulant le circuit électronique 13 formant un assemblage 27. Le procédé de réalisation comprend une étape 104 de stratification de l'assemblage 27, c'est-à-dire une étape de pressage et chauffe de l'assemblage 27. Cette étape permet la fusion des films de colle et assure l'homogénéité de l'empilage. A ce stade du procédé selon l'invention, il n'y a pas de drain thermique positionné sous le composant électronique 10. Il s'agit d'une pluralité de couches en matériaux organiques disposées autour du premier ensemble formé par le circuit 13 et la couche d'interconnexion 12. Lors de l'étape 104 de stratification, la colle thermoplastique remplit les espaces laissés libres lors des étapes précédentes pendant l'étape d'empilage. Après l'étape 104 de stratification, le circuit électronique 13 se retrouve noyé dans le matériau thermoplastique, par exemple le LCP ou le FEP (abréviation de fluoroéthylène propylène), ce qui assure sa protection ultérieure contre l'humidité.

Enfin, le procédé selon l'invention comprend une étape 105 de réalisation d'une surface métallique 26 thermiquement conductrice disposée en contact au moins partiellement avec la face arrière 18 de la plaque métallique 16. Cette étape est nécessaire pour reconnecter la face arrière du circuit électronique 13. En effet, cette face arrière 18 de la plaque métallique 16 a aussi été noyée dans la couche thermoplastique LCP lors du procédé de réalisation.

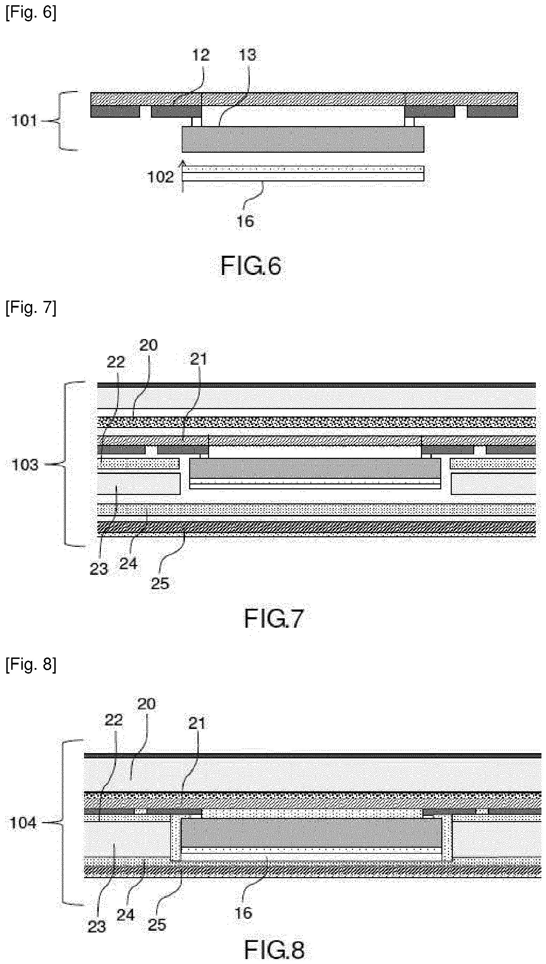

La figure 6 représente schématiquement les étapes d'assemblage 101 et de couplage 102 du procédé selon l'invention.

La figure 7 représente schématiquement l'étape d'empilage 103 du procédé selon l'invention. Les figures 6 et 7 sont schématiques et ont pour objectif de montrer séparément les couches pendant leur assemblage. A titre d'explication, la couche d'interconnexion 12 est, une fois l'assemblage réalisé, bien entourée de toutes parts par les couches organiques.

La figure 8 représente schématiquement l'étape de stratification 104 du procédé selon l'invention.

Le procédé selon l'invention comprend avantageusement une étape 106 de réalisation de blindage du circuit électronique 13 par un réseau 31 d'éléments métalliques 32, 33 disposé à distance du circuit électronique 13, de sorte à former une cage de Faraday 34 incluant le circuit électronique 13. L'étape 106 de réalisation de blindage du circuit électronique 13 peut comprendre une étape 107 de disposition du réseau 31 d'éléments métalliques 32 sur le pourtour 35 du composant électronique 10 et/ou une étape 108 de disposition du réseau 31 d'éléments métalliques 33 à la périphérie 36 du composant électronique 10. Les perçages métallisés, qui sont réalisés entre la face supérieure et la face inférieure de l'empilage, permettent de créer une cage de Faraday, et aussi de connecter la masse arrière du semiconducteur avec la face supérieure de l'empilage.

La figure 9 représente schématiquement les étapes de réalisation 105 d'une surface métallique thermiquement conductrice et de réalisation 106 de blindage du circuit électronique du procédé selon l'invention.

L'étape 105 de réalisation de la surface métallique 26 thermiquement conductrice disposée en contact au moins partiellement avec la face arrière 18 de la plaque métallique 16 comprend une étape 109 d'usinage du composant électronique 10 vers la face arrière 18 de la plaque métallique 16 et une étape 110 de métallisation. Comme expliqué précédemment, la face arrière du circuit électronique 13 est noyée dans la couche thermoplastique. Il est donc nécessaire de reconnecter la face arrière du circuit électronique 13. L'usinage du composant électronique 10 peut être fait par des perçages disposés de manière adéquate ou un fraisage (comme représenté sur la figure 9), réalisés avec un laser, ou tout autre procédé, par exemple mécanique, adapté. Ce procédé de réalisation mettant en œuvre une étape d'usinage du composant est rendu possible car les couches de diélectriques disposées sous la plaque métallique 16 sont suffisamment fines pour éviter tout problème. En outre, la plaque métallique 16 assure une protection de la face arrière du circuit 13 pendant l'étape 109 d'usinage. L'utilisation d'un laser CO2 convient à ce type de procédé car celui-ci pyrolyse les matériaux organiques et est réfléchi par les métaux (et donc par la plaque métallique 16). Suivant le besoin de dissipation thermique requis, on peut soit retirer quasiment toute la surface sous le circuit électronique 13 (comme représenté sur la figure 2), soit créer des connexions par trous laser (comme représenté sur la figure 3).

Après l'étape 109 d'usinage a lieu l'étape 110 de métallisation de la surface usinée. Lors de cette étape, la matière enlevée est remplacée par un métal contenant du cuivre. Avantageusement, cette étape de métallisation comprend une première étape de métallisation dans une solution pour dépôt de cuivre sur quelques micromètres, puis une deuxième étape de recharge électrolytique pour déposer du cuivre sur une plus grande épaisseur.

On obtient ainsi un empilage permettant un fonctionnement optimisé pour le circuit électronique 13 encapsulé, aussi bien du point de vue électrique que thermique. Un autre avantage résultant du procédé selon l'invention est que le circuit électronique 13 encapsulé ne subit pas de contraintes mécaniques pendant la mise en œuvre du procédé. Après découpe et billage, le boîtier obtenu peut être utilisé et dispose de bonnes propriétés électriques et une bonne résistance à l'humidité, avec une fiabilité significativement améliorée par rapport aux composants de l'art antérieur.

Contrairement au procédé de packaging décrit dans le document EP 3089211, le procédé de réalisation selon l'invention ne résout pas le problème de double référence mécanique pendant l'étape de pressage. Le procédé selon l'invention procède différemment, en traitant la double référence mécanique dans une phase ultérieure du procédé par élimination de matière sous le composant, c'est-à-dire du côté de la face arrière du circuit électronique 13. En d'autres termes, le procédé selon l'invention ne prévoit pas de drain thermique lors de l'empilage des couches autour du circuit électronique 13, ni de report de masse. Le drain thermique et le report de masse sont réalisés ultérieurement, après usinage du composant. Autrement dit, dans l'art antérieur, la réalisation d'un tel empilage fonctionnel nécessitait le collage de la face arrière du semiconducteur sur la couche métallique inférieure extérieure. C'est ce collage qui induisait des contraintes mécaniques sur le semiconducteur, car les différences de hauteurs entre l'empilage et le composant impliquait d'appuyer sur ce dernier pour être sûr qu'il soit collé. Le procédé de l'invention permet d'éviter d'être obligé de coller le semiconducteur sur une couche métallique inférieure extérieure et ainsi de supprimer tous les efforts mécaniques qui se produisaient dans le premier procédé.

Le procédé selon l'invention présente un avantage par rapport au fait de seulement utiliser plusieurs couches LCP comme dans l'art antérieur. En effet, l'utilisation de plusieurs couches LCP ne suffit pas pour éliminer le besoin d'appuyer sur le composant pour le coller. Le fait de pouvoir coller une plaque métallique sur le composant avant de mettre celui-ci (et sa couche comportant des connexions électriques) dans l'empilage, comme réalisé dans l'invention, supprime le besoin d'appuyer dessus : cette plaque va protéger le composant dans les phases finales du procédé de fabrication. En effet, après pressage, on usine (avec un laser) la face arrière de l'empilage jusqu'à la plaque : en l'absence de celle-ci, il y aurait un risque avéré de détruire le composant. Une fois qu'une ouverture de la taille de la plaque est réalisée, on met en œuvre des étapes pour rajouter du métal dans la cavité réalisée. De cette manière, on ramène la partie métallique collée sur le composant dans le plan inférieur de l'empilage total. L'empilage final obtenu a alors des caractéristiques supplémentaires issues de ces modifications. La plaque collée sur la face arrière du composant a été épaissie et peut donc évacuer la chaleur qui sera produite par le composant pendant son fonctionnement. De plus, la colle utilisée est conductrice électrique (mais on pourrait aussi assembler le composant avec un alliage de brasure pour obtenir le même résultat), et ainsi permet de rapporter le potentiel de la face arrière du semiconducteur sur la face arrière de l'empilage.

L'invention concerne ainsi le composant électronique directement obtenu par le procédé de réalisation décrit ci-dessus.

Le procédé de réalisation selon l'invention permet d'éviter toute pénétration d'humidité sous forme liquide au niveau de l'encapsulation du circuit électronique 13, et donc de supprimer tout problème de corrosion par effet électrochimique, au niveau des empilages métalliques des circuits en présence de l'électrolyte eau.

La technologie dite de circuit imprimé permet la réalisation d'une structure de type « cage de Faraday » qui permet d'isoler électriquement les circuits qui se trouvent à l'intérieur et ainsi d'éliminer le problème de diaphonie d'un composant à l'autre.

Il en résulte un composant électronique pouvant contenir des fonctions hyperfréquences garantissant les propriétés d'étanchéité pour protéger les technologies encapsulées qui sont sensibles à l'humidité, comme les technologies MMIC. L'invention permet de garantir une fiabilité de report renforcé par rapport à l'existant pour être en adéquation avec le niveau d'intégration. L'invention permet aussi de minimiser les problèmes de diaphonie, pour pouvoir positionner des fonctions les plus intégrées possibles. Aussi, l'invention permet d'assurer une dissipation thermique en adéquation avec le niveau d'intégration demandée. Enfin, avec un composant électronique selon l'invention, il est possible d'avoir les caractéristiques mécaniques tridimensionnelles permettant de disposer d'une bonne capacité d'empilage des fonctions hyperfréquences.

L'intérêt de l'invention est d'améliorer l'étanchéité du composant, de manière générale et en complément du brevet EP3089211. En outre, ce type de solution représente une alternative aux ASIC, MMIC, etc., présente un NRC (abréviation du terme anglo-saxon « Non Recurring Costs » signifiant « coûts non récurrents ») de développement plus faibles que d'autres solutions connues de l'art antérieur et constitue une solution robuste.

## Revendications

1. Procédé de réalisation d'un composant électronique (10) comprenant un premier ensemble (11) comprenant une couche d'interconnexion (12) et un circuit électronique (13) ayant une face avant (14) et une face arrière (15), connecté à la couche d'interconnexion (12) par la face avant (14), le procédé comprenant les étapes suivantes:
a. assemblage (101) d'une plaque métallique (16) ayant une face avant (17) et une face arrière (18), sur la face arrière (15) du circuit électronique (13);
b. couplage thermique et électrique (102) de la plaque métallique (16) au circuit électronique (13) par un agent de couplage (19) entre la face avant (17) de la plaque métallique (16) et la face arrière (15) du circuit électronique (13), l'agent de couplage étant une colle ou une brasure d'alliage métallique;
c. empilage (103) de plusieurs couches en matériaux organiques (20, 21, 22, 23, 24, 25) autour du premier ensemble (11) et de la plaque métallique (16) selon une technique de type circuit imprimé et encapsulant le circuit électronique (13) formant un assemblage (27) ;
d. stratification (104) de l'assemblage (27) ;
e. réalisation (105) d'une surface métallique (26) thermiquement conductrice disposée en contact au moins partiellement avec la face arrière (18) de la plaque métallique (16).

2. Procédé de réalisation selon la revendication 1, **caractérisé en ce qu'**il comprend une étape (106) de réalisation de blindage du circuit électronique (13) par un réseau (31) d'éléments métalliques (32, 33) disposé à distance du circuit électronique (13), de sorte à former une cage de Faraday (34) incluant le circuit électronique (13).

3. Procédé de réalisation selon la revendication 2, **caractérisé en ce que** l'étape (106) de réalisation de blindage du circuit électronique (13) comprend une étape (107) de disposition du réseau (31) d'éléments métalliques (32) sur la périphérie latérale extérieure (35) du composant électronique (10).

4. Procédé de réalisation selon la revendication 2, **caractérisé en ce que** l'étape (106) de réalisation de blindage du circuit électronique (13) comprend une étape (108) de disposition du réseau (31) d'éléments métalliques (33) à la périphérie (36) du composant électronique (10).

5. Procédé de réalisation selon l'une quelconque des revendications 1 à 4, **caractérisé en ce que** l'étape (105) de réalisation de la surface métallique (26) thermiquement conductrice disposée en contact au moins partiellement avec la face arrière (18) de la plaque métallique (16) comprend une étape (109) d'usinage du composant électronique (10) vers la face arrière (18) de la plaque métallique (16) et une étape (110) de métallisation.

6. Composant électronique (10) comprenant un premier ensemble (11) comprenant une couche d'interconnexion (12) et un circuit électronique (13) ayant une face avant (14) et une face arrière (15), connecté à la couche d'interconnexion (12) par la face avant (14), **caractérisé en ce que** le premier ensemble (11) comprend:
a. une plaque métallique (16) ayant une face avant (17) et une face arrière (18), assemblée sur la face arrière (15) du circuit électronique (13) ;
b. un agent de couplage (19) entre la face avant (17) de la plaque métallique (16) et la face arrière (15) du circuit électronique (13) configuré pour connecter thermiquement et électriquement la plaque métallique (16) au circuit électronique (13), l'agent de couplage étant une colle ou une brasure d'alliage métallique ;
et **en ce que** le composant électronique (10) comprend :
c. plusieurs couches en matériaux organiques (20, 21, 22, 23, 24, 25) empilées autour du premier ensemble (11) selon une technique de type circuit imprimé et encapsulant le circuit électronique (13);
d. une surface métallique (26) thermiquement conductrice disposée en contact au moins partiellement avec la face arrière (18) de la plaque métallique (16).

7. Composant électronique (10) selon la revendication 6, **caractérisé en ce qu'**il comprend un réseau (31) d'éléments métalliques (32, 33) disposé à distance du circuit électronique (13), de sorte à former une cage de Faraday (34) incluant le circuit électronique (13).

8. Composant électronique (10) selon la revendication 7, **caractérisé en ce que** le réseau (31) d'éléments métalliques (32) est disposé sur la périphérie latérale extérieure (35) du composant électronique (10).

9. Composant électronique (10) selon la revendication 7, **caractérisé en ce que** le réseau (31) d'éléments métalliques (33) est disposé à la périphérie (36) du composant électronique.

10. Composant électronique (10) selon l'une quelconque des revendications 6 à 9, **caractérisé en ce qu'**au moins une parmi la ou les couches en matériaux organiques est une couche en matériau thermoplastique.
